# FASCICULE DE BREVET EUROPEEN

(11) **EP 0 335 453 B1**
(45) Date de publication et mention de la délivrance du brevet: **08.09.1993**
(21) Numéro de dépôt: 89200743.6
(22) Date de dépôt: 23.03.1989
(51) Int. Cl.: C30B 19/06, C30B 29/40

(54) **Procédé d'obtention d'une couche monocristalline ternaire hétéro-épitaxiée sur une couche binaire et creuset pour sa mise en oeuvre**
Verfahren und Tiegel zur Herstellung einer ternären, heteroepitaktischen Schicht auf einer binären Schicht
Process for obtaining a single crystal heteroepitaxial ternary layer on a binary layer and crucible therefor

(30) Priorité: 29.03.1988 FR 8804077
(43) Date de publication de la demande: 04.10.1989
(73) Titulaire: PHILIPS COMPOSANTS, 92150 Suresnes (FR); Philips Electronics N.V., 5621 BA Eindhoven (NL)
(72) Inventeur: Grijol, Laurent, Société Civile S.P.I.D., F-75007 Paris (FR); Le Martret, Catherine, c/o Societé Civile S.P.I.D., F-75007 Paris (FR); Baladi, Béatrice, c/o Societé Civile S.P.I.D., F-75007 Paris (FR)
(74) Mandataire: Charpail, François

(56) Documents cités:
- FR-A- 2 481 324
- US-A- 3 762 367
- US-A- 3 925 117
- US-A- 3 990 392

## Description

La présente invention a pour objet un procédé d'obtention par hétéro-épitaxie d'au moins une première couche monocristalline d'un composé ternaire sur au moins un substrat monocristallin de composition binaire, dans lequel une première solution saturée du composé ternaire est amenée en contact avec ledit substrat, l'ensemble étant porté de manière homogène à une première température, puis refroidi avec une première vitesse décroissante donnée jusqu'à une deuxième température de manière à réaliser ladite épitaxie, ladite première couche ayant une épaisseur au moins égale à 100 microns (µm).

Selon l'art antérieur, ce procédé classique permet d'obtenir une épaisseur maximale de couche épitaxiée d'environ 100 microns. Un creuset correspondant à ce procédé a été décrit dans le brevet FR 1600341 déposé par la Demanderesse.

La technique utilisée consiste à disposer un ou plusieurs substrats en GaAs dans un creuset et à les recouvrir d'une solution ternaire saturée (GaAlAs). L'épaisseur de la croissance est limitée en raison du fait que la solution s'appauvrit localement en Al au fur et à mesure de la croissance et du refroidissement. Or la réalisation de diodes à substrat GaAlAs transparent combinant un haut rendement et faible consommation nécessite une couche de substrat ternaire d'au moins 150 microns d'épaisseur.

Plusieurs articles publiés récemment, dont notamment celui paru dans "Electronique Industrielle" n°133 novembre 1987 p.27-28 notamment, mentionnent explicitement que les problèmes technologiques relatifs à la réalisation d'une couche de 150 microns de GaAlAs ne sont pas résolus. Or les débouchés potentiels des diodes électroluminescentes à substrat transparent apparaissent très importants.

Il est par ailleurs patent que les procédés actuellement connus et qui ont pour objet d'améliorer les conditions de croissance épitaxiale relèvent de techniques de laboratoire, non extrapolables à une fabrication industrielle dans des conditions de coût satisfaisantes.

Un premier procédé connu améliorant la croissance de couches de composition binaire, en l'occurence en GaAs, a été proposé par J.T. DALY et al dans le Journal of Cristal Growth 78 (1986) North Holland p.291-302. Il consiste à réaliser une circulation laminaire permanente de la solution sur le substrat de manière à assurer que la solution soit constamment saturée à l'interface avec le substrat. Ce procédé est compliqué de mise en oeuvre et son coût le destine plus à des travaux de laboratoire qu'à une fabrication industrielle.

En outre, son efficacité éventuelle pour la croissance de couches ternaires n'a pas été évaluée.

L.E. STONE et al dans "Growth of thick GaₓAl₁₋ₓAs layers by liquid phase epitaxy" (Texas Instruments Inc) ont suggéré un procédé pour réaliser des couches épaisses de GaAlAs, dans lequel un substrat en GaAs est amené à la surface d'une solution saturée, l'ensemble étant placé dans un four produisant non pas une température homogène de l'ensemble, mais un gradient de température vertical, assurant le transport de matériau ternaire en phase liquide et le maintien de la croissance. La croissance s'opére à température constante ou tout du moins avec une légère décroissance de température au cours du temps.

Ce deuxième procédé connu impose de traiter les substrats un à un, et il ne se prête ni au traitement collectifs de substrats, ni à la réalisation successive, sans refroidissement complet des substrats, de plusieurs couches épitaxiées. En outre, la stabilisation du gradient thermique est relativement longue. Ce procédé ne convient donc pas non plus à une mise en oeuvre industrielle.

La présente invention a alors pour objet un procédé de fabrications de substrats ternaires, par exemple GaAlAs, par hétéroépitaxie sur un substrat binaire, par exemple GaAs, de manière à atteindre des épaisseurs plus grandes, de l'ordre de 200 microns et plus pour le GaAlAs.

L'idée de base de l'invention vient de la mise à profit de l'existence d'une croûte polycristalline à la surface du bain, à la fin d'une épitaxie classique de grande épaisseur (environ 100 microns) réalisée dans un creuset dans lequel le substrat est recouvert par la solution et, avec refroidissement par décroissance thermique entre deux températures. La Demanderesse a constaté que cette croûte était de composition ternaire, donc contenant 50% d'arsenic, et a émis l'hypothèse qu'elle provenait de microgermes de GaAlAs qui se forment spontanément au cours de la décroissance thermique et qui, moins denses que la solution, viennent flotter à la surface du bain y former une masse solide.

Or, pour remédier au phénomène d'appauvrissement de la solution en As au niveau de l'interface de croissance cristalline, il est justement recherché de provoquer une circulation apte à enrichir localement la solution en As.

La Demanderesse a constaté qu'en disposant le substrat à épitaxier en contact avec la surface de la solution, ce qui pourrait être considéré a priori comme déconseillé en raison précisément de la formation sur cette surface d'une croûte indésirable en fin d'épitaxie, on pouvait obtenir des épaisseurs épitaxiées plus grandes, toutes choses égales par ailleurs, que dans le cas où le substrat est recouvert par la solution. La Demanderesse interprète ce phénomène surprenant par le fait que les germes riches en As qui viennent flotter au niveau de l'interface de cristallisation, se redissolvent dans la couche d'interface de solution appauvrie en As et l'enrichissent en As ce qui permet de poursuivre plus avant la croissance.

Le procédé selon l'invention est ainsi caractérisé en ce que ladite mise en contact de la première solution du composé ternaire, par exemple GaAlAs, notamment dopé, avec le substrat, par exemple en GaAs, notamment dopé, du type opposé est réalisée en disposant une face inférieure dudit substrat en contact avec la surface de ladite solution, en ce que la première température est comprise entre 850 et 880°C, en ce que ladite deuxième température est de l'ordre de 700°C et en ce que la première vitesse de décroissance est comprise entre 0,6 et 1,2°C/mn.

On notera par ailleurs qu'il est connu du brevet US 3 762 367 de réaliser une croissance épitaxiale en disposant un substrat à la surface successivement de plusieurs solutions épitaxiales, mais le procédé ainsi décrit ne concerne spécifiquement que des couches épitaxiales de faibles épaisseurs (au maximum 12 microns) avec des décroissances thermiques d'au maximum 20°C. Dans ces conditions et à ces températures, le phénomène de formation éventuelle d'une croûte à la surface de la solution n'est absolument pas susceptible de se produire. Ce phénomène de formation d'une croûte intervient en effet lorsqu'on réalise par épitaxie une couche de grande épaisseur. Par conséquent, le brevet US 3 762 367 ne donne aucune instruction pour surmonter le préjugé de l'homme de métier quant à ce genre de technique, pour la réalisation des couches de grande épaisseur.

Selon une variante préférée, le procédé comporte une étape ultérieure de mise en contact du substrat épitaxié avec la surface d'une deuxième solution saturée du composé ternaire, l'ensemble étant refroidi avec une deuxième vitesse de décroissance donnée jusqu'à une troisième température de manière à obtenir une deuxième couche monocristalline, notamment de manière à créer une jonction entre deux couches épitaxiées et par exemple de compléter la fabrication avec une deuxième couche d'épaisseur classique pour former une diode électroluminescente. On évite ainsi d'avoir à refroidir jusqu'à la température ambiante le substrat épitaxié entre les deux épitaxies.

Le procédé peut comporter, notamment en vue de réaliser des diodes électro-luminescentes à substrat GaAlAs transparent, une étape d'enlèvement du substrat de composition binaire.

L'invention concerne également un creuset pour épitaxie à deux bains dans lequel des substrats à épitaxier sont disposés dans un porte-substrats qui est monté fixe en translation dans un corps de creuset, et qui présente une région centrale où est ménagé un réceptacle ayant un fond présentant au moins une ouverture pour recevoir les substrats, creuset qui comporte une première et une deuxième tirettes dont le déplacement permet de mettre les substrats successivement en contact avec les deux bains, soit : une première et une deuxième solutions d'épitaxie, contenues respectivement dans deux réservoirs, d'un dispositif porte-solution, muni d'une première et d'une deuxième fentes destinées à écouler au moment voulu, les dites solutions d'épitaxie, et le dispositif porte-solution étant placé au dessus du porte-substrats.

Un tel creuset est connu en particulier du document de brevet FR-A-2 481 324 déposé par la Demanderesse. L'une des deux tirettes, dans ce cas, porte les deux réservoirs, et les solutions viennent baigner la face supérieure des substrats disposés sous cette tirette.

Pour des raisons indiquées ci-dessus, il est souhaité de réaliser l'épitaxie en plaçant les substrats en contact avec la surface du liquide, tout en permettant de réaliser deux épitaxies à la suite l'une de l'autre ce qui évite d'avoir à refroidir entre temps le substrat épitaxié et donc de subir les inconvénients de l'oxydation éventuelle de l'aluminium.

Dans ce but le creuset selon l'invention est conforme aux caractéristiques de la revendication 6.

Selon un mode de réalisation préféré, l'ouverture du porte-substrats présente des nervures espacées de manière à recevoir les bords des substrats, et les substrats sont recouverts d'une plaque de mêmes dimensions que le réceptacle.

Ceci permet d'assurer que la solution ne vienne pas mouiller la face supérieure des substrats, et limite son écoulement.

L'invention sera mieux comprise à la lecture de la description qui va suivre, donnée à titre d'exemple non limitatif, en liaison avec les dessins qui représentent :
- les figures 1 et 2 illustre deux procédés de l'art antérieur, respectivement à circulation laminaire continue de solution et à gradient thermique vertical.
- les figures 3a et 3b représentent respectivement en coupe verticale et en vue de dessus un creuset pour la mise en oeuvre du procédé selon l'invention, et la figure 3c une vue de dessus du porte-substrats.
- les figures 4a à 4d illustrant le fonctionnement du creuset des figures 3a et 3b.
- les figures 5a à 5c représentent des courbes de croissance épitaxiale de GaAlAs sur substrat GaAs, respectivement d'épaisseur de couche en fonction de la vitesse de descente en température à une température de départ donnée, d'épaisseur de couche en fonction de la hauteur de solution à une température de départ donnée, et l'épaisseur de la couche épitaxiale en fonction de la température de départ à vitesse de descente en température donnée.

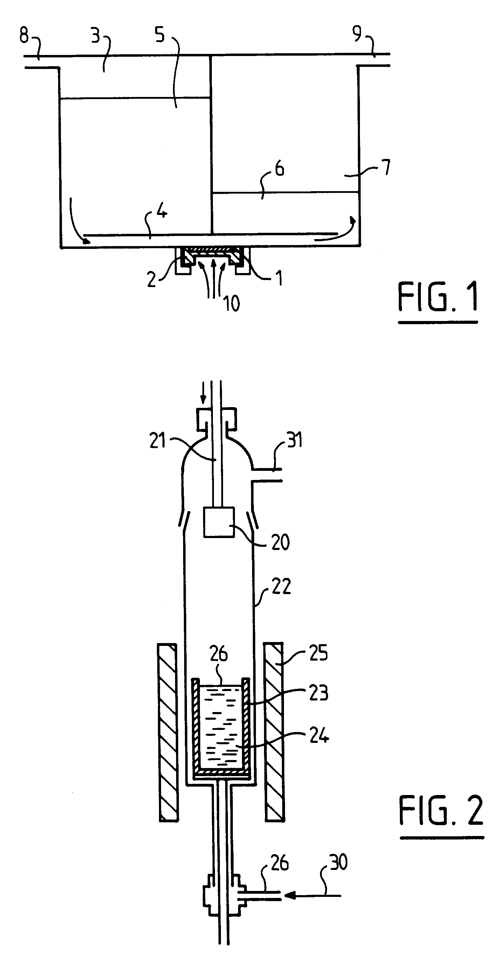

La figure 1 illustre la technique de croissance épitaxiale à flot laminaire de solution utilisé par J.T. DALY et al pour la croissance de GaAs. Une solution saturée 5 de température T₀ contenue dans un réservoir 3 situé à gauche sur la figure est connecté par l'intermédiaire d'un canal rectangulaire étroit 4 à un réservoir 7 situé à droite sur la figure. Une injection de gaz en 8 cause une surpression entraînant une circulation de la solution 5 à travers le canal 4, vers le réservoir 7. Un porte substrat 2 maintient un substrat 1 en contact avec la solution en un pont du canal 4 où le flux de solution est laminaire. Le substrat 1 est refroidi jusqu'à une température T' inférieure à T₀ tout au long du processus d'épitaxie, grâce à une circulation de gaz 10. Cette technique n'a été évaluée que pour des croissances de couche de composition binaire et en tout état de cause, elle nécessite la mise en oeuvre d'un appareillage compliqué, de grandes dimensions en raison de la quantité de solution requise (100cm³) et de ce fait difficile à réguler en température. Le traitement d'une quantité importante de substrats apparaît difficile à réaliser. Pour toutes ces raisons, ce procédé n'est pas industrialisable dans de bonnes conditions.

La figure 2 correspond au procédé de croissance d'une couche de composition ternaire tel que décrit par STONE et al dans l'article précité.

Un creuset 23 rempli d'une solution 24 de Ga est placé dans un four 25 et un substrat 20 est mis en contact avec la surface 26 de la solution 24. Le principe de croissance est le transport de matériau ternaire mettant en oeuvre un gradient thermique. A cet effet, une source ternaire solide est disposé dans la solution à un niveau de celle-ci qui est de 10°C plus chaud que le substrat 20. En raison de la différence de solubilité dûe au gradient thermique, une migration et un transport de matière se produit et maintient la croissance.

La croissance est réalisée uniquement à partir de matière circulant par thermo-migration. La croissance proprement dite n'est pas rapide (moins d'un micron par minute). Un inconvénient est la stabilisation du gradient thermique qui prend quatre heures environ pour un four traitant un seul substrat.

En outre, il est pratiquement impossible de réaliser des fours à gradient thermique permettant de traiter une pluralité de substrats en raison des problèmes d'homogénéité de température qui se poseraient avec de telles géométries.

Selon l'invention au contraire, l'épitaxie de la couche ternaire s'effectue dans des conditions qui sont très proches des méthodes traditionnelles de l'épitaxie liquide. En effet, ainsi qu'on va le montrer dans la suite de la description, il n'est besoin ni de provoquer une circulation laminaire dans la solution, ni de mettre en oeuvre un gradient thermique, mais d'utiliser un phénomène secondaire jusque là constaté mais non analysé.

Ce phénomène est l'apparition d'une croûte polycristalline de composition thernaire que l'on recueille à la surface du bain en fin d'épitaxie. Plus particulièrement, l'analyse de la composition de cette croûte montre qu'il ne s'agit pas de la cristallisation sur place de la solution, mais qu'elle provient d'éléments qui ont migré à cet endroit. Comme la solution ne présente pas de gradient thermique qui, d'ailleurs seulement dans des conditions très précises, aurait pu entraîner une migration, la Demanderesse a émis l'hypothèse qu'il s'agissait de micro-germes solides se produisant localement et spontanément dans le bain d'épitaxie et venant flotter à la surface.

L'invention repose alors sur l'idée que, si on dispose les substrats à épitaxier à la surface du bain d'épitaxie, ces micro-germes, loin de perturber l'épitaxie comme on aurait pu le penser, la favorisent au contraire car il se redissolvent à l'interface d'épitaxie appauvri en As et le réenchérissent ainsi en As ce qui permet de poursuivre plus loin la croissance.

On va maintenant décrire, à titre d'exemple un creuset permettant de réaliser une épitaxie selon l'invention. Ce creuset est prévu pour contenir deux solutions, ce qui permet si on le désire, de réaliser deux épitaxies à la suite l'une de l'autre sans avoir à refroidir le substrat et le sortir du four d'épitaxie.

En effet, un tel refroidissement, outre un rallongement des temps de fabrication, peut causer des inconvénients en raison des risques d'oxydation de l'Al de la couche de GaAlAs, gênante pour réaliser des épitaxies ultérieures.

Le creuset comporte un corps de creuset 40 présentant une première extrémité 41 comportant un alésage 42 susceptible de recevoir un pion 43, et une deuxième extrémité 44 et un fond 45. Un porte substrats 70 fixe en translation par rapport au corps du creuset 40 est pris en sandwich entre, à sa partie supérieure, un porte-solutions 80 et un système mobile en translation et comportant deux tirettes 50 et 60.

Le porte-solutions 80 comporte deux réservoirs 85 et 86 séparés par un rebord 83 et présentant chacun sur son fond une fente, respectivement 81 et 82, destinée à l'écoulement de la solution à travers des fentes correspondantes, disposées juste en dessous, respectivement 71 et 72, qui sont ménagés à deux extrémités sur des rebords du porte-substrats 70.

La première tirette 50 présente une partie centrale comportant un rebord 54 dont la face supérieure a une dimension au moins égale à celle des fentes 71 et 72, de manière à pouvoir alternativement obturer l'une ou l'autre lorsque la tirette 50 est actionnée entre ses positions extrêmes. La partie centrale de la tirette 50 présente également un sabot 53 coulissant le long du fond 45 du corps de creuset 40.

La première tirette présente une première 51 et une deuxième partie 52 disposées de part et d'autre de la partie centrale, et traversant les extrémités respectivement 44 et 41 du corps de creuset 40.

La deuxième tirette 51 est une simple plaque d'épaisseur sensiblement égale au dépassement en hauteur du rebord 54 par rapport à la deuxième partie 52 de la tirette 50, et elle comporte, au voisinage de son extrémité proche du rebord 54 une ouverture 61 propre à coopérer avec le pion 43.

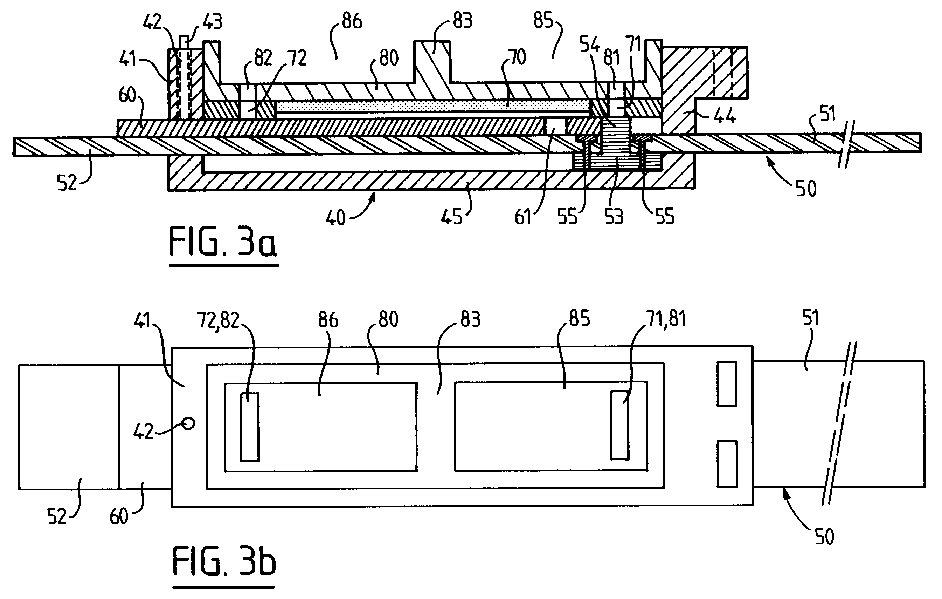

Plus particulièrement selon la figure 3c, le porte-substrats comporte un réceptacle 73 présentant en son fond une ouverture 74 bordée par des mesures 75 sur lesquelles reposent les bords des substrats 90, l'ouverture 74 dégageant la majeure partie de la face inférieure des substrats 90. Une plaque rectangulaire 76 de même dimensions que le réceptacle 73 vient recouvrir les substrats 90 en les maintenant sur les nervures 75, et limite également l'écoulement des solutions en les empêchant notamment de baigner la face supérieure des substrats 90.

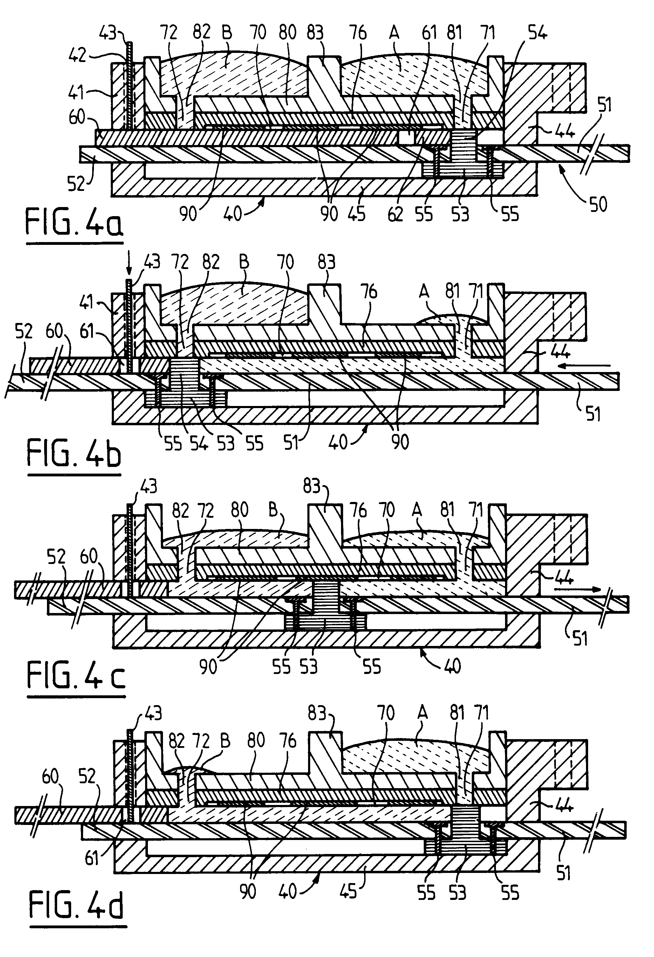

Selon les figures 4a à 4d, les différentes opérations relatives à une épitaxie double sont les suivantes.

Les réservoirs 85 et 86 sont remplis de solutions saturées ternaires A et B, par exemple du Ga dans lequel a été dissout à saturation du GaAs et de l'Al avec addition d'au moins un dopant correspondant aux caractéristiques désirées pour les couches épitaxiées. Par exemple, dans le cas d'une diode, les dopants des deux solutions sont de types de conductivité opposés.

A la figure 4a, le sabot 53 de la tirette 50 est en butée contre l'extrémité 44 du corps de creuset 40, et son rebord 54 obture la fente 71, empêchant l'écoulement de la solution A. La deuxième tirette 60 obture quant à elle la fente 72 empêchant l'écoulement de la solution B. L'ensemble est porté au premier palier de température.

A la figure 4b, la tirette 50 est poussée en direction de l'extrémité 41 du corps de creuset 40 jusqu'à venir en butée sur celle-ci. La solution A peut ainsi s'écouler sur le dessus de la première partie de la tirette 51 et venir lécher la face inférieure des substrats 90. On réalise alors la décroissance de la température selon la vitesse choisie jusqu'à arriver à la deuxième température.

On retire ensuite la tirette 50 de manière que le sabot 53 revienne en butée contre l'extrémité 44 du corps de creuset 40. La deuxième tirette 60 reste en position, le pion 43 étant descendu par gravité dans l'ouverture 61, ce qui fait que la solution B vient recouvrir la deuxième partie 52 de la première tirette 50, et baigner la face inférieure des substrats 90. La solution B est saturée de manière à se trouver à l'équilibre à la deuxième température.

La descente en température est poursuivie avec la vitesse choisie (éventuellement en maintenant la même vitesse) jusqu'à arriver à la troisième température. La deuxième couche ainsi réalisée a une épaisseur classique pour former par exemple une diode électroluminescente. Si aucune autre épitaxie n'est prévue, la troisième température peut être la température ambiante (la croissance épitaxiale s'arrête d'elle-même vers 550°C).

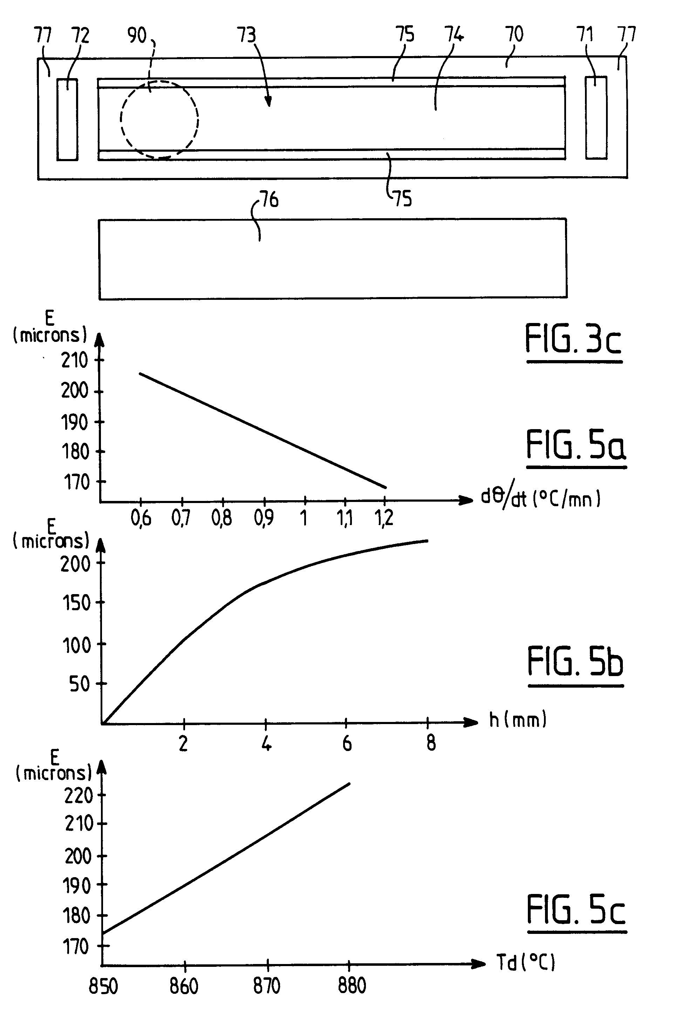

Les figures 5a à 5c représentent les courbes caractéristiques de l'épaisseur maximale E exprimée en microns d'une couche épitaxiée de GaAlAs en fonction respectivement de la vitesse de variation de la température dϑ/dt exprimée en °C par minute, pour une température de départ de 880°C, de la hauteur de la solution exprimée en mm pour une température de départ de 880°C, et en fonction de la température de départ exprimée en °C pour un hauteur h la solution de 8mm et une vitesse de variation de température dϑ/dt de 0,6°C/mn. La deuxième température est de l'ordre de 700°C.

Par exemple, pour T = 880°C, h = 8mm et dϑ/dt = 0,6°C/mn, on obtient une couche épitaxiée de GaAlAs d'un peu plus de 200 microns d'épaisseur au bout de 5 heures, soit une vitesse de croissance de 0,7 microns/mn.

Dans le cas où on envisage de fabriquer des diodes électro-luminescentes à substrat transparent, lesquelles nécessitent ainsi qu'on l'a mentionné ci-dessus, une couche de substrat GaAlAs d'au moins 150 microns d'épaisseur, une étape ultérieure connue en soi consiste à enlever par des moyens connus (attaque chimique sélective) le substrat initial de GaAs qui a servi à la croissance. Du fait que ces diodes présentent un substrat transparent, la lumière émise par la diode est très peu absorbée dans celle-ci, et les rendements lumineux sont bien supérieurs à celui des diodes à substrat non transparent (GaAs).

## Revendications

1. Procédé d'obtention par hétéro-épitaxie liquide d'au moins une première couche monocristalline d'un composé ternaire sur au moins un substrat monocristallin de composition binaire, dans lequel une première solution saturée du composé ternaire est amenée en contact avec ledit substrat, l'ensemble étant porté de manière homogène à une première température, puis refroidi avec une première vitesse de décroissance donnée jusqu'à une deuxième température de manière à réaliser ladite épitaxie ladite première couche ayant une épaisseur au moins égale à 100 microns (µm) caractérisé en ce que ladite mise en contact est réalisée en disposant une face inférieure dudit substrat en contact avec la surface de ladite solution, en ce que la première température est comprise entre 850 et 880°C, en ce que la deuxième température est de l'ordre de 700°C et en ce que la première vitesse de décroissance est comprise entre 0,6 et 1,2°C/mn.

2. Procédé selon la revendication 1, caractérisé en ce que le substrat est en GaAs d'un premier type de conductivité et la première solution est constituée par du Ga dans lequel est dissout de l'Al et du GaAs, et au moins un dopant de manière à réaliser une couche épitaxiée dopée.

3. Procédé selon la revendication 1 caractérisé en ce qu'il comporte une étape ultérieure de mise en contact du substrat ainsi épitaxié avec la surface d'une deuxième solution du composé ternaire, l'ensemble étant refroidi avec une deuxième vitesse de décroissance donnée jusqu'à une troisième température, pour former une deuxième couche épitaxiée.

4. Procédé selon la revendication 3, caractérisé en ce que le substrat est en GaAs d'un premier type de conductibilité, en ce que la première solution est constituée par du Ga dans lequel est dissout de l'Al et du GaAs et au moins un dopant du premier type de conductivité de manière à réaliser la première couche épitaxiée avec le premier type de conductivité et en ce que la deuxième solution est constituée par du Ga dans lequel est dissout de l'Al et du GaAs et au moins un pant d'un deuxième type de conductivité opposé au premier de manière à réaliser la deuxième couche épitaxiée avec le deuxième type de conductivité.

5. Procédé selon une des revendications 3 ou 4 caractérisé en ce qu'il comporte une étape ultérieure d'enlèvement du substrat de composition binaire.

6. Creuset pour épitaxie à deux bains dans lequel des substrats à épitaxier sont disposés dans un porte-substrats (70) qui est monté fixe en translation dans un corps de creuset (10), et qui présente une région centrale où est ménagé un réceptacle (73) ayant un fond présentant au moins une ouverture (74) pour recevoir les substrats (90) , creuset qui comporte une première (50) et une deuxième (60) tirettes dont le déplacement permet de mettre les substrats successivement en contact avec les deux bains, soit : une première (A) et une deuxième (B) solutions d'épitaxie, contenues respectivement dans deux réservoirs (85), (86) d'un dispositif porte-solution (80), muni d'une première (81) et d'une deuxième (82) fentes destinées à écouler au moment voulu, les dites solutions d'épitaxie, et le dispositif porte-solution étant placé au dessus du porte-substrats,
caractérisé en ce que le dispositif porte-solution est fixe en translation par rapport au corps de creuset (40), en ce que le porte-substrats est disposé de manière que son réceptacle (73) soit situé en dessous, exposant ainsi la face inférieure des substrats, lorsqu'ils y sont disposés, au contact de la surface de l'une ou l'autre des solutions d'épitaxie, en ce que le porte-substrats présente une troisième (71) et une quatrième (72) fentes, lesquelles sont disposées sur des rebords (77) bordant de part et d'autre la dite région centrale, et placées immédiatement au dessous des première (81) et deuxième (82) fentes, en ce que la première tirette (50) présente dans une partie centrale, un rebord (54) ayant une face supérieure de dimension au moins égale à celle des troisième (71) et quatrième (72) fentes, et une première (51) et une deuxième (52) parties de part et d'autre du rebord, en ce que la deuxième tirette (60) est superposée à la deuxième partie (52) de la première tirette (50), la deuxième tirette ayant une épaisseur sensiblement égale à celle dudit rebord (54) et présentant au voisinage d'un bord (62) jouxtant ledit rebord (54), un trou (61) dans lequel est susceptible de s'engager un pion de blocage (43) reposant par son poids sur la surface supérieure de la deuxième tirette (60), le pion de blocage (43) étant disposé à une première extrémité (41) du corps du creuset jouxtant le deuxième réservoir (86), de telle sorte que la première tirette (50) est translatable entre une position arrière où elle vient en butée sur une deuxième extrémité (44) du corps du creuset (40) jouxtant le premier réservoir (85) et une position avant où, d'une part, le rebord (54) de la première tirette (50) n'obturant plus la première fente, la première solution (A) s'étant écoulée sur la première partie (51) de la première tirette vient lécher la face inférieure des substrat (90) et où, d'autre part, le pion de blocage (43) est retombé par gravité dans le trou (61) de la deuxième tirette (60), ce qui fait que le retour de la première tirette (50) vers la position arrière provoque le reflux de la première solution (A) vers le premier réservoir (85), et l'écoulement de la deuxième solution (B) sur la deuxième partie (52) de la première tirette (50) de manière à venir lécher la face inférieure des substrats (90).

7. Creuset selon la revendication 6, caractérisé en ce que l'ouverture (74) du porte-substrats (70) présente des nervures (75) espacées de manière à recevoir les bords des substrats (90), et en ce que les substrats (90) sont recouverts d'une plaque (76) de même dimension que le réceptacle (73).

## Claims

1. A method of obtaining by liquid hetero-epitaxy at least one first monocrystalline layer of a ternary compound on at least one monocrystalline substrate of a binary composition, in which a first solution saturated with the ternary compound is brought into contact with said substrate, the assembly being raised uniformly to a first temperature, thereafter cooled at a first temperature decreasing rate to a second temperature in such a manner as to effect said epitaxy, said first layer having a thickness of at least 100 microns (µm), characterized in that the said contact is effected by bringing a lower surface of said substrate into contact with the surface of said solution, in that the first temperature lies between 850^{o} and 880^{o}C, in that the second temperature is of the order of 700^{o}C, and in that the first temperature decreasing rate lies between 0.6 and 1.2^{o}C/min.

2. A method as claimed in Claim 1, characterized in that the substrate is made of GaAs of a first conductivity type and the first solution is constituted by Ga in which Al and GaAs have been dissolved with at least one doping agent in such a manner as to realize a doped epitaxial layer.

3. A method as claimed in Claim 1, characterized in that it includes a further step in which the substrate thus epitaxied is brought into contact with the surface of a second solution of the ternary compound, the assembly being cooled at a second given temperature decreasing rate to a third temperature for forming a second epitaxial layer.

4. A method as claimed in Claim 3, characterized in that the substrate is made of GaAs of a first conductivity type, in that the first solution is constituted by Ga in which Al and GaAs have been dissolved with at least one doping agent of the first conductivity type in such manner as to form the first epitaxial layer with the first conductivity type, and in that the second solution is constituted by Ga in which Al and GaAs and at least one doping agent of a second conductivity type which is the opposite of the first conductivity type have been dissolved in such a manner as to provide the second epitaxial layer of the second conductivity type.

5. A method as claimed in one of the Claims 3 or 4, characterized in that it includes a further step in which the substrate of binary composition is removed.

6. A crucible for double-bath epitaxy in which substrates to be epitaxied are arranged in a substrate carrier (70) which is mounted in a fixed translational position in a crucible body (10) and which comprises a central region in which a receptacle (73) is made having a bottom with at least one aperture (74) for accommodating the substrates (90), which crucible comprises a first (50) and a second (60) slide whose displacements render it possible to bring the substrates into contact successively with two baths: i.e. a first (A) and a second (B) epitaxy solution contained in two respective reservoirs (85, 86) of a solution holder (80) which is provided with a first (81) and with a second (82) slit arranged so that the said epitaxy solutions can flow through them at desired moments, while the solution holder is positioned above the substrate carrier, characterized in that the solution holder is in a fixed translational position relative to the crucible body (40), in that the substrate carrier is so arranged that its receptacle (73) is situated at its lower side, thus exposing the lower surface of any substrates provided therein to one or the other of the epitaxy solutions, in that the substrate carrier comprises a third (71) and a fourth (72) slit which are made on raised edges (77) which bound the said central region on either side, these slits being positioned exactly below the first (81) and second (82) slit, in that the first slide (50) comprises, in a central portion, a raised edge (54) whose upper surface has a size at least equal to that of the third (71) and fourth (72) slit, and a first (51) and a second (52) portion on either side of said raised edge, and in that the second slide (60) is superimposed on the second portion (52) of the first slide (50), the second slide having a thickness which is substantially equal to that of the said raised edge (54) and having a hole (61) adjacent an edge (62) which adjoins the said raised edge (54), into which hole (61) a blocking pin (43), which rests by its own weight on the upper surface of the second slide (60), can enter, the blocking pin (43) being arranged at a first end (41) of the crucible body adjoining the second reservoir (86) such that the first slide (50) is translatable between a rear position in which it bears on a second end (44) of the crucible body (40) adjoining the first reservoir (85) and a front position in which, on the one hand, the raised edge (54) of the first slide (50) no longer closes the first slit and the first solution (A) flows over the first portion (51) of the first slide and wets the lower surfaces of the substrates (90), and in which, on the other hand, the blocking pin (43) returns into the hole (61) of the first slide (60) by gravity, so that the return of the first slide (50) into the rear position leads to the first solution (A) flowing back into the first reservoir (85) and the second solution (B) flowing out over the second portion (52) of the first slide (50) so as to wet the lower surfaces of the substrates (90).

7. A crucible as claimed in Claim 6, characterized in that the aperture (74) of the substrate carrier (70) comprises ribs (75) which are spaced apart in such a manner as to accommodate the edges of the substrate (90), and in that the substrates (90) are covered by a plate (76) of the same dimensions as the receptacle (73).

## Patentansprüche

1. Verfahren zum Herstellen wenigstens einer ersten monokristallinen Schicht einer ternären Verbindung mittels Heteroepitaxie auf wenigstens einem monokristallinen Substrat einer Binärzusammensetzung, wobei in diesem Verfahren eine erste mit der ternären Verbindung gesättigte Lösung mit dem Substrat in Kontakt gebracht wird, das Ganze einheitlich auf eine erste Temperatur gebracht wird, danach mit einer ersten vorgegebenen abfallenden Geschwindigkeit auf eine zweite Temperatur abgekühlt wird, um die Epitaxie durchzuführen, wobei die erste Schicht eine Dicke gleich wenigstens 100 µm hat, dadurch gekennzeichnet, daß die Kontaktherstellung mit dem Substrat durch Herstellung des Kontakts einer unteren Oberfläche des Substrats mit der Oberfläche der Lösung verwirklicht wird, und daß die erste Temperatur zwischen 850 und 880°C liegt, daß die zweite Temperatur in der Größenordnung von 700°C beträgt und daß die erste Temperaturabfallgeschwindigkeit zwischen 0,6 und 1,2°C per Minute liegt.

2. Verfahren nach Anspruch 1, dadurch gekennzeichnet, daß das Substrat aus GaAs von einem ersten Leitfähigkeitstyp und die erste Lösung von Ga, in dem eine Al-Menge und GaAs gelöst ist, und wenigstens einem Dotierungsmittel zusammengesetzt ist, um eine dotierte epitaxierte Schicht zu verwirklichen.

3. Verfahren nach Anspruch 1, dadurch gekennzeichnet, daß es eine Endstufe umfaßt, in der das epitaxierte Substrat mit der Oberfläche einer zweiten Lösung der ternären Verbindung in Kontakt gebracht wird, wobei das Ganze mit einer zweiten vorgegebenen Abfallgeschwindigkeit auf eine dritte Temperatur zum Erzeugung einer zweiten epitaxierten Schicht abgekühlt wird.

4. Verfahren nach Anspruch 3, dadurch gekennzeichnet, daß das Substrat aus GaAs von einem ersten Leitfähigkeitstyp zusammengesetzt, die erste Lösung aus Ga, in dem eine Al-Menge und GaAs gelöst ist, und wenigstens einem Dotierungsmittel zusammengesetzt ist, um die erste epitaxierte Schicht vom ersten Leitfähigkeitstyp zu verwirklichen, die zweite Lösung aus GaAs von einem ersten Leitfähigkeitstyp zusammengesetzt, und die zweite Lösung aus Ga, in dem eine Al-Menge und GaAs gelöst ist, und wenigstens einem Dotierungsmittel von einem zweiten Leitfähigkeitstyp zusammengesetzt ist, um die zweite epitaxierte Schicht vom zweiten Leitfähigkeitstyp zu verwirklichen.

5. Verfahren nach einem der Ansprüche 3 oder 4, dadurch gekennzeichnet, daß es eine Endstufe umfaßt, in der das Substrat mit Binärzusammensetzung entfernt wird.

6. Tiegel für Doppelbadepitaxie, in dem die zu epitaxierenden Substrate in einem Substratträger (70) angeordnet werden, der seitlich in einem Tiegelkörper (10) festgesetzt wird, und der einen mittleren Bereich enthält, in dem ein Behälter (73) angeordnet ist, der einen Boden mit wenigstens einer Öffnung (74) zum Aufnehmen der Substrate (90) enthält, wobei der Tiegel eine erste (50) und eine zweite (60) Ausziehplatte enthält, deren Verschiebung die Möglichkeit gibt, die Substrate aufeinanderfolgend mit den beiden Bädern in Kontakt zu bringen, d.h. mit einer ersten (A) und einer zweiten (B) Epitaxielösung, die sich in zwei Behältern (85), (86) einer Lösungsträgereinrichtung (80) befinden, die einen ersten (81) und einen zweiten Schlitz (82) zum Ausfließen zum verlangten Zeitpunkt enthält, wobei die Epitaxielösungen und die Lösungsträgereinrichtung über dem Substratträger angeordnet sind, dadurch gekennzeichnet, daß die Lösungsträgereinrichtung in bezug auf den Tiegelkörper (40) seitlich festgesetzt ist, daß der Substratträger derart angeordnet ist, daß sein Behälter (73) sich darunter befindet, wodurch so die untere Fläche der Substrate freiliegt, während sie dabei mit der Oberfläche mit einer oder der anderen der Epitaxielösungen angebracht sind, daß der Substratträger einen dritten (71) und einen vierten (72) enthält, die auf den Rändern (77) an beiden Seiten des Zentralbereichs angeordnet und direkt unter dem ersten (81) und dem zweiten (82) Schlitz angebracht sind, daß die erste Ausziehplatte (50) in einem Zentralteil eine Kante (54) aufweist, die eine obere Fläche mit einer Abmessung wenigstens gleich der des dritten (71) und des vierten (72) Schlitzes und einen ersten (51) und einen zweiten (52) Anteil an beiden Seiten der Kante hat, und daß die zweite Ausziehplatte (60) auf dem zweiten Anteil (52) der ersten Ausziehplatte (50) angebracht ist, wobei die zweite Ausziehplatte eine Dicke im wesentlichen gleich der Kante (54) hat und in der Nähe eines Randes (62) neben der Kante (54) eine Öffnung (61) enthält, in die ein Blockierstift (43) einrasten kann, der durch das Eigengewicht auf der obere Fläche der zweiten Ausziehplatte (60) ruht, in einem ersten Ende (41) des Tiegelkörpers neben dem zweiten Behälter (86) derart angeordnet ist, daß die erste Ausziehplatte (50) zwischen einer hinteren Stellung, in der sie an ein zweites Ende (44) des Tiegelkörpers (40) neben dem ersten Behälter (85) anläuft, und einer vorderen Stellung verschiebbar ist, in der einerseits die Kante (54) der ersten Ausziehplatte (50) den ersten Schlitz nicht länger blockiert, die auf den ersten Teil (51) der ersten Ausziehplatte ausgeströmte erste Lösung (A) die untere Fläche des Substrats (90) jetzt benetzt, und zum anderen der Blockierstift (43) durch Schwerkraft in das Loch (61) der zweiten Ausziehplatte (60) fällt, wodurch die Rückkehr der ersten Ausziehplatte (50) in die hintere Stellung das Zurückfließen der ersten Lösung (A) nach dem ersten Behälter (85) und das Ausströmen der zweiten Lösung (B) auf dem zweiten Teil (52) der ersten Ausziehplatte (50) derart bewirkt, daß die unter Fläche des Substrats (90) benetzt wird.

7. Tiegel nach Anspruch 6, dadurch gekennzeichnet, daß die Öffnung (74) des Substratträgers (70) im Abstand voneinander liegende Rippen (75) zum Aufnehmen der Ränder der Substrate (90) aufweist, und daß die Substrate (90) mit einer Platte (76) abgedeckt werden, die dieselben Abmessungen wie die des Behälters (73) hat.
